# EUROPEAN PATENT APPLICATION

(11) **EP 4 730 212 A1**
(43) Date of publication of application: **22.04.2026**
(21) Application number: 25187431.9
(22) Date of filing: 04.07.2025
(51) Int. Cl.: G06N 5/022, G06N 3/0475

(54) **METHOD OF GENERATING DRIVING SCENARIOS AND APPARATUS THEREOF**

(30) Priority: 15.10.2024 KR 20240140645
(71) Applicant: Hyundai Mobis Co., Ltd., Gangnam-gu Seoul 06141 (KR)
(72) Inventor: CHU, Heon Jeong, 16891 Yongin-si, Gyeonggi-do (KR); PARK, Hee Kang, 16891 Yongin-si, Gyeonggi-do (KR)
(74) Representative: Jung, Minkyu

(57) **Abstract**

Disclosed are a method of generating a driving scenario and an apparatus thereof. The method includes extracting situations in a text form from collected data by using artificial intelligence, configuring each of the situations extracted in the text form as a node and generating a situation graph by assigning a weight to an edge between nodes, and generating the driving scenario by using the situation graph.

## Description

### CROSS-REFERENCE TO RELATED APPLICATION

This application claims the benefit of priority to Korean Patent Application No. 10-2024-0140645, filed in the Korean Intellectual Property Office on October 15, 2024, the entire contents of which are incorporated herein by reference.

### TECHNICAL FIELD

The present disclosure relates to a driving scenario generation technology, and more particularly, to a method of generating a driving scenario that generates the driving scenario based on generative artificial intelligence (AI), and an apparatus thereof.

### BACKGROUND

Autonomous driving is a technology that safely transports vehicles and people to a destination without accidents by performing perception, decision, and control by itself. An autonomous vehicle uses various sensors such as cameras, radar, ultrasound, and lidar to sense the surrounding environment, and uses artificial intelligence (AI) technology to recognize surrounding objects and control the vehicle's behavior, thereby ensuring safe driving without accidents. Automobile manufacturers provide products to consumers by performing various verifications to satisfy the intended functions/performance to ensure safe autonomous driving performance.

Generative AI, which is a next stage technology of artificial intelligence, is a field of artificial intelligence technology that learns various domains such as images, text, and videos to generate new contents. The learned model may provide high-quality results in response to various demands, and may even provide output at a level that surpasses human creativity. In the field of large language model (LLM), OpenAI's Chat GPT is a representative example of generative AI. When receiving a requirement of a user, the Chat GPT generative AI analyzes the requirement on its own and provides the most appropriate answer, so many people use the Chat GPT generative AI.

### SUMMARY

The present disclosure has been made to solve the above-mentioned problems occurring in the prior art while advantages achieved by the prior art are maintained intact.

One aspect of the present disclosure provides a method of generating a driving scenario that is capable of generating the driving scenario based on generative artificial intelligence (AI), and an apparatus thereof.

Another aspect of the present disclosure provides a method of generating a driving scenario that is capable of automatically generating a large number of driving scenarios for verifying autonomous driving performance in a device such as a vehicle, a robot, and the like performing autonomous driving, and an apparatus thereof.

Still another aspect of the present disclosure provides a method of generating a driving scenario that is capable of automatically generating a driving scenario for verifying autonomous driving performance and an image thereof, and an apparatus thereof.

The technical problems to be solved by the present disclosure are not limited to the aforementioned problems, and any other technical problems not mentioned herein will be clearly understood from the following description by those skilled in the art to which the present disclosure pertains.

According to one aspect of the present disclosure, a method of generating a driving scenario includes extracting situations in a text form from collected data by using artificial intelligence, configuring each of the situations extracted in the text form as a node and generating a situation graph by assigning a weight to an edge between nodes, and generating the driving scenario by using the situation graph.

According to an embodiment, the extracting of the situations may include extracting the situations in the text form from the collected data related to an accident situation by using generative AI.

According to an embodiment, the extracting of the situations may include extracting the situations as a phrase or a sentence from the collected data.

According to an embodiment, the generating of the situation graph may include generating the situation graph by configuring the situations extracted in the text form into situation nodes, configuring information for each of the collected data as accident nodes, and assigning edges to edges after connecting the edges between the situation nodes and the accident nodes.

According to an embodiment, the generating of the situation graph may include generating the situation graph by assigning the weight to each of the first edge and a second edge after connecting a first edge between the situation nodes having a relationship with the accident nodes and connecting the second edge between mutually exclusive situation nodes among the situation nodes.

According to an embodiment, the first edge may be given different weights depending on a degree of relationship between the accident node and the situation node, and the second edge may be given different weights depending on a degree of exclusivity between the situation nodes.

According to an embodiment, the generating of the driving scenario may include determining at least one situation node among the situation nodes connected to the accident nodes with the first edge based on the weight assigned to the first edge, and generating the driving scenario by using the at least one situation node.

According to an embodiment, the method may further include generating an image corresponding to the driving scenario by using an image generation model.

According to another aspect of the present disclosure, a method of generating a driving scenario includes extracting situations in a text form from collected data by using artificial intelligence, configuring each of the situations extracted in the text form into situation nodes, and configuring information about each of the collected data as central nodes, assigning weights to edges by connecting the edges between the situation nodes and the central nodes, and generating the driving scenario based on the weights assigned to the edges.

According to an embodiment, the assigning of the weights may include assigning the weight to each of the first edge and a second edge after connecting a first edge between the situation nodes having a relationship with the central nodes and connecting the second edge between mutually exclusive situation nodes among the situation nodes.

According to an embodiment, the generating of the driving scenario may include determining at least one of the situation nodes connected to the central nodes with the first edge based on the weight assigned to the first edge, and generating the driving scenario by using the at least one situation node.

According to an embodiment, the method may further include generating an image corresponding to the driving scenario by using an image generation model.

According to still another aspect of the present disclosure, an apparatus for generating a driving scenario includes a data analysis device that extracts situations in a text form from collected data by using artificial intelligence, a data management device that generates a situation graph by configuring each of the situations extracted in the text form as a node and assigning a weight to an edge between nodes, and a scenario generation device that generates the driving scenario by using the situation graph.

According to an embodiment, the data analysis device may extract the situations in the text form from the collected data related to an accident situation by using generative AI.

According to an embodiment, the data analysis device may extract the situations as a phrase or a sentence from the collected data.

According to an embodiment, the data management device may generate the situation graph by configuring the situations extracted in the text form into situation nodes, configuring information for each of the collected data as accident nodes, and assigning weights to edges after connecting the edges between the situation nodes and the accident nodes.

According to an embodiment, the data management device may generate the situation graph by assigning the weight to each of the first edge and a second edge after connecting a first edge between the situation nodes having a relationship with the accident nodes and connecting the second edge between mutually exclusive situation nodes among the situation nodes.

According to an embodiment, the first edge may be given different weights depending on a degree of relationship between the accident node and the situation node, and the second edge may be given different weights depending on a degree of exclusivity between the situation nodes.

According to an embodiment, the scenario generation device may determine at least one of the situation nodes connected to the accident nodes with the first edge based on the weight assigned to the first edge, and generate the driving scenario by using the at least one situation node.

According to an embodiment, the apparatus may further include an image generation device that generates an image corresponding to the driving scenario by using an image generation model.

The features briefly summarized above with respect to the present disclosure are merely exemplary aspects of the detailed description of the present disclosure described below and do not limit the scope of the present disclosure.

### BRIEF DESCRIPTION OF THE DRAWINGS

The above and other objects, features and advantages of the present disclosure will be more apparent from the following detailed description taken in conjunction with the accompanying drawings:
FIG. 1 is a flowchart illustrating a method of generating a driving scenario according to an embodiment of the present disclosure;
FIG. 2 is a diagram illustrating an example of a data collection process;
FIG. 3 is a diagram illustrating an example of a process of extracting situations from collected data;
FIG. 4 is a diagram illustrating an example of a process of generating a situation graph;
FIG. 5 is a diagram illustrating an example of a process of generating a driving scenario by using a situation graph;
FIG. 6 is a block diagram illustrating a configuration of an apparatus for generating a driving scenario according to another embodiment of the present disclosure; and
FIG. 7 is a block diagram illustrating a computing system for executing a method of generating a driving scenario according to an embodiment of the present disclosure.

### DETAILED DESCRIPTION

Hereinafter, various embodiments of the inventive concept will be described in detail with reference to the accompanying drawings, so that those skilled in the art can easily carry out the inventive concept. However, the inventive concept is not limited to the embodiments set forth herein and may be modified variously in many different forms.

In describing the embodiments of the present specification, when a specific description of the related art is deemed to obscure the subject matter of the embodiments of the present specification, the detailed description will be omitted. In the drawings, the portions irrelevant to the description will not be shown in order to make the present disclosure clear.

It will be understood that when an element is referred to as being "connected" or "coupled" to another element, it may be directly connected or indirectly connected to another element. In addition, when some part 'includes' or "has" some elements, unless explicitly described to the contrary, it means that other elements may be further included but not excluded.

Expressions such as "first," or "second," and the like, may express their elements regardless of their priority or importance and may be used to distinguish one element from another element but is not limited to these components. Therefore, without departing from the scope of the present disclosure, a first component of one embodiment may be referred to as a second component of another embodiment. Similarly, a second component of one embodiment may be referred to as a first component of another embodiment.

In the present disclosure, components that are distinguished from each other are only for clearly describing characteristics, and do not mean that the components are necessarily separated. That is, a plurality of components may be integrated to form a single hardware or software unit, or a single component may be distributed to form a plurality of hardware or software units. Accordingly, such integrated or distributed embodiments are included in the scope of the present disclosure, even though not mentioned separately.

In the present disclosure, components described in various embodiments do not necessarily mean essential components, and some may be optional components. Therefore, an embodiment composed of a subset of components described in an embodiment is also included in the scope of the present disclosure. In addition, embodiments including other components in addition to the components described in various embodiments are also included in the scope of the present disclosure.

In the present disclosure, expressions of positional relationships used herein, such as upper, lower, left, right, and the like, are described for convenience of description. When viewing the drawings shown in this specification in reverse, the positional relationship described in the specification may be interpreted in the opposite manner.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases.

Autonomous driving is currently in a transitional phase from Lv2 to Lv3, which is called the full autonomous driving stage, and requires more sophisticated and reliable performance quality. Manufacturers build more robust scenarios to validate performance. However, driving situations and conditions are not the same depending on weather, road, region, country, and the like, and driving laws and drivers' driving tendencies also differ from country to country, making it difficult to guarantee performance by utilizing the same scenario.

Corner/edge cases that are rare or difficult to occur during driving are constructed and evaluated as scenarios, but the scope is limited to confirm performance of Lv3 or higher. The reason is pointed out as one of the reasons why Lv3 autonomous driving is not yet available on the market.

Accidents occur due to unpredictable variables and environments, so it is difficult for human creativity and thinking to consider all possible cases. Therefore, even if autonomous driving implements the functions of Lv5, it is still far away for humans to devise an evaluation scheme that can verify and guarantee it.

Embodiments of the present disclosure aim to improve the reliability of learning and performance verification of autonomous driving algorithms by automatically generating a large number of driving scenarios for verifying autonomous driving performance in devices such as vehicles and robots that perform autonomous driving based on generative AI.

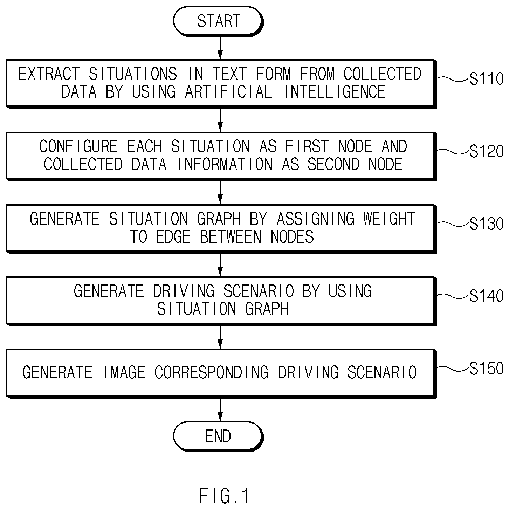

FIG. 1 is a flowchart illustrating a method of generating a driving scenario according to an embodiment of the present disclosure. In this case, FIG. 1 may be a flowchart illustrating a method performed in a device, a server, or a system for generating a driving scenario.

Referring to FIG. 1, in operation S110, a method of generating a driving scenario according to an embodiment of the present disclosure extracts situations in the form of text from collected data by using artificial intelligence (AI) such as generative AI.

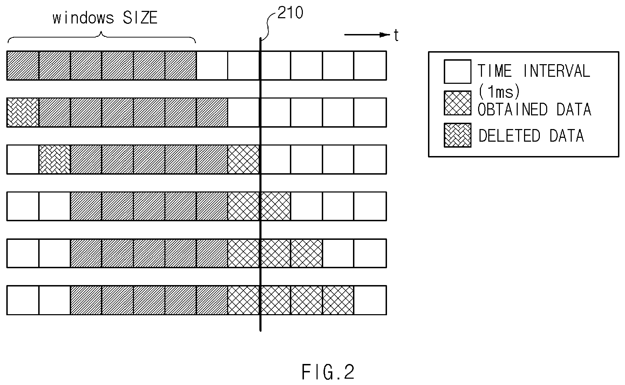

The collected data used in the method of the present disclosure may be data collected in real time from a device for collecting data or may be data collected in advance, and a scheme of collecting data will be described in detail in FIG. 2.

Hereinafter, in explaining the technology of the present disclosure, it is assumed that the collected data is accident data related to an accident. Of course, the collected data applied to the technology of the present disclosure is not limited or restricted to accident data, and may include all data for generating scenarios related to driving of a device such as a vehicle, a robot, and the like.

Before describing the technology of the present disclosure, the terms used in the technology of the present disclosure are defined as follows.

An accident means an event in which damage to life or property has occurred or is likely to occur, and a situation, which is an individual factor that may contribute to an accident, may include "it is foggy", "a pedestrian is jaywalking", "a vehicle is cutting in", and the like. A scenario may mean an event that may be created by combining several situations and occur in reality.

According to an embodiment, in operation S110, the accident data may be analyzed using generative artificial intelligence that inputs pre-collected or stored accident data and may be extracted in the form of text describing the situation. In this case, in operation S110, situations may be extracted as phrases or sentences rather than words and by extracting situations as phrases or sentences, it is possible to minimize the ambiguity of the result processed/analyzed by the generative AI.

According to an embodiment, operation S110 may extract several situations that may contribute to an accident from accident data by using a language model and the like.

According to an embodiment, in operation S110, several situations, which may contribute to an accident, may be extracted from a schematic diagram of an accident situation, a photograph of an accident scene, and the like by using an image-to-text model, and the like.

According to an embodiment, the situations extracted in operation S110 may be categorized according to situations such as weather, vehicle type, road type, and the like, and by embedding/clustering the situations using a language model within one category, similar situations may be managed as one and mutually exclusive situations may be identified. For example, the method of the present disclosure may manage "it is foggy" and "it is densely foggy" as one, and identify "the weather is clear" as a mutually exclusive situation with fog.

When situations are extracted from the accident data in operation S110, each of the extracted situations is configured as a first node (hereinafter, referred to as a "situation node"), and information on each of the accident data is configured as a second node (hereinafter, referred to as a "accident node") in operation S120.

According to an embodiment, in operation S120, a situation node may include detailed situation nodes classified by category. For example, in operation S120, situations may include detailed situation nodes such as road situation nodes, driving situation nodes, vehicle situation nodes, weather situation nodes, and the like. That is, in operation S120, each situation and each accident may be configured as each node.

When situation nodes and accident nodes are configured in operation S120, in operation S130, a situation graph is generated by assigning weights to edges between the situation nodes and accident nodes.

According to an embodiment, in operation S130, a situation graph may be generated by connecting a first edge, for example, a relationship edge, between situation nodes having relationship with accident nodes, and connecting a second edge, for example, an exclusivity edge, between mutually exclusive situation nodes among the situation nodes, and then assigning weights to the first edge and the second edge, respectively.

In this case, the first edge may be given different weights depending on the degree of relationship between the accident node and the situation node, and the second edge may be given different weights depending on the degree of exclusivity between the situation nodes.

According to an embodiment, in operation S130, in relation to the accident node, the first edge may be given different weights by considering the order in which it has a high relationship with the corresponding accident and has a great influence on the corresponding accident, the weight value assigned to the first edge may be determined by a business operator or individual providing the technology of the present disclosure, and the highest and lowest weights assigned to the first edge may be determined in advance.

According to an embodiment, in operation S130, a lower weight than a weight assigned to a first edge may be assigned to a second edge connected between mutually exclusive situation nodes. In addition, depending on the situation, different weights may be assigned to the second edge, and a weight of a preset small value may be assigned equally. Of course, the second edge may be weighted based on the degree of mutual exclusivity between the situation nodes when the degree of mutual exclusivity is calculated, and the higher the degree of mutual exclusivity, the higher or lower the weight that may be given to the second edge. In this case, the scheme of calculating the degree of mutual exclusivity between situation nodes and the weight given to the second edge may be determined by the business operator or individual providing the technology of the present disclosure.

Furthermore, the situation graph structure for expressing the relationship between the accident nodes and the situation nodes may be changed, and in the changed situation graph structure, the first edge described above may be connected depending on the degree of relationship between the situation nodes and the second edge may be connected between the accident node and the situation node. That is, the situation graph generated according to the method of the present disclosure may have various structures in various manners.

When a situation graph is generated in operation S130, in operations S140 and S150, a driving scenario is generated using the situation graph, and an image or video corresponding to the generated driving scenario is generated.

According to an embodiment, in operation S140, at least one of the situation nodes connected to the accident nodes through the first edge may be determined based on the weight assigned to the first edge, and the driving scenario may be generated using the at least one situation node.

According to an embodiment, in operation S140, situation nodes with high accident contribution may be identified based on the weight assigned to the first edge by using a graph algorithm such as GNN, PageRank, and the like, and a high-quality or high-likelihood driving scenario may be generated by a scheme such as including a specified percentage or more of the identified situation nodes.

That is, in operation S140, when a driving scenario is generated by selecting only situation nodes that are not related to an accident or by selecting situation nodes that are mutually exclusive or cannot occur simultaneously, only unrealistic or low-quality driving scenarios may be generated. Therefore, by generating a driving scenario by selecting situation nodes with a high relationship based on the weight assigned to the first edge, a high-quality driving scenario may be generated.

According to an embodiment, in operation S150, the driving scenario may be generated as an image, a video, and the like by using a generative artificial intelligence model such as a text-to-image, a text-to-video model, or the like.

Hereinafter, the method of the present disclosure will be described in detail with reference to FIGS. 2 to 5.

FIG. 2 is a diagram illustrating an example of a data collection process.

FIG. 2 illustrates a process of collecting driving data by using a data acquisition device such as a data logging device installed in a vehicle.

As illustrated in FIG. 2, a vehicle with a data logging device installed may obtain driving data, and the obtained data may include data collected by a camera, a radar, a lidar, or an ultrasonic sensor used for autonomous driving, controller and actuator data of the vehicle, and the like.

In this case, driving data may be obtained in a sliding window manner. Specifically, data may be collected every millisecond. As time passes, previous data may be deleted, while data for a specified time period before the current time, for example, 1 hour, is continuously maintained. That is, data is obtained by sliding a 1-hour window over time. In this case, the data collection time unit may be 1 ms and the collection time period may be 1 hour, but such a data collection time unit and collection time period may vary depending on a situation.

In the process of obtaining driving data from a vehicle, when an abnormal driving event 210 occurs or a user explicitly turns on the data storage function, the sliding window function is turned off and data is not deleted from the corresponding time point until the abnormal driving event 210 ends or the storage function is turned off. That is, all data is obtained from 1 hour before the occurrence of an abnormal event to the end of the event.

In this case, the abnormal driving events may include all dangerous events that may cause an accident, such as lane departure, skidding, collision, driver inattention (e.g., distraction), drowsiness, and driving negligence of another driver.

The driving data obtained from each vehicle may be transmitted to a preset server, for example, a server performing the method of the present disclosure, so that the server may collect the driving data obtained from all vehicles and generate a driving scenario based on the driving data collected in such a manner.

Of course, the collected data used in the method of the present disclosure is not limited or restricted to data obtained from an autonomous vehicle, and various highly reliable data that have already been collected and stored may be utilized.

Because it is often difficult not only for people but also for autonomous driving systems to drive in an accident situation, when utilizing highly reliable accident data, it is possible to construct a high-quality driving scenario that is highly probable, uncommon, and difficult.

When a traffic accident occurs, the accident analysis organization in each country, such as German In-depth accident study (GIDAS), conducts an in-depth investigation/analysis of accidents and creates a database of accident situation diagrams, accident scene photos, and the like. Accordingly, the method of the present disclosure may utilize such pre-collected and stored high-reliability accident data.

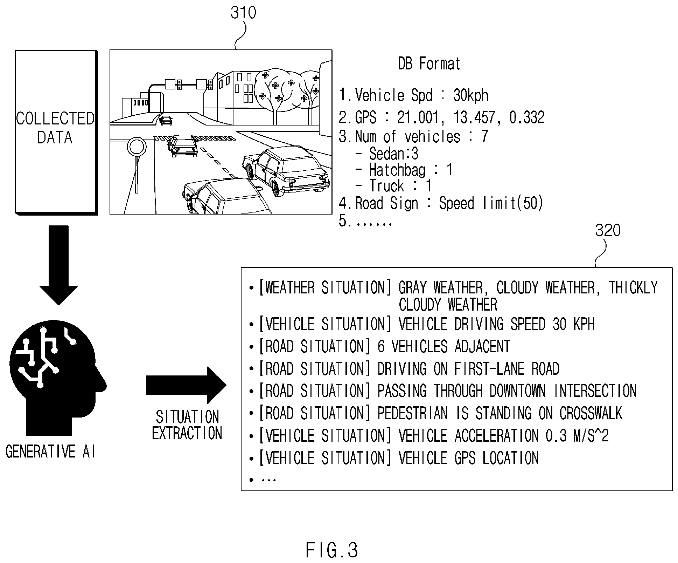

FIG. 3 is a diagram illustrating an example of a process of extracting situations from collected data.

As illustrated in FIG. 3, a method according to an embodiment of the present disclosure may extract situations from collected data 310 by using generative artificial intelligence, and categorize the extracted situations according to a weather situation, a vehicle situation, a road situation, and the like.

In addition, the weather situation, vehicle situation and road situation 320 categorized may be embedded/clustered within a single category by using a language model, so that similar situations may be managed as one.

For example, as illustrated in FIG. 3, "gray weather," "cloudy weather," and "thickly cloudy weather" may be managed as a single weather situation as similar situations, and although not illustrated, "clear weather" may be managed as a separate weather situation because it is a mutually exclusive situation with "cloudy weather."

As described above, the method according to an embodiment of the present disclosure may manage extracted similar situations as one cluster, and may generate a situation graph by using each situation.

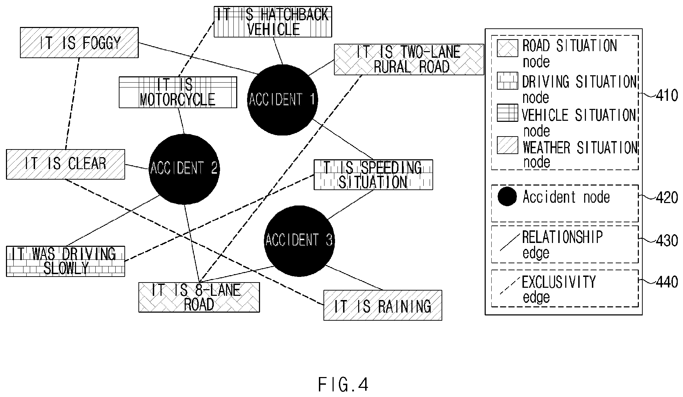

FIG. 4 is a diagram illustrating an example of a process of generating a situation graph.

As illustrated in FIG. 4, the situation graph may include a situation node 410, an accident node 420, a relationship edge 430 which is a first edge, and an exclusivity edge 440 which is a second edge.

The situation node 410 in FIG. 4 includes a road situation node, a driving situation node, a vehicle situation node, and a weather situation node. The road situation node includes two situations: "It is a two-lane rural road" and "It is an eight-lane highway". The driving situation node includes two situations: "It is speeding" and "It was driving slowly". The vehicle situation node includes two situations: "It is a hatchback vehicle" and "It is a motorcycle". The weather situation node includes three situations: "It is foggy", "It is clear", and "It is raining". Of course, the situation nodes 410 that constitute the situation graph are not limited or restricted to the situations illustrated in FIG. 4. For the convenience of explanation, the situations are described in a limited manner, and the explanation is made using the situations illustrated in FIG. 4.

The accident node 420 includes three accident data of accident 1, accident 2 and accident 3. The relationship edge 430, which is an edge connecting the accident node 420 and the situation node 410, may be connected when related to the accident, and the exclusivity edge 440, which is an edge connecting situation nodes, may be connected when two situations are mutually exclusive.

In FIG. 4, the accident 1 node may be connected to the situation nodes of "fog", "hatchback vehicle", "rural two-lane road", and "speeding" by relationship edges. The incident 2 node is connected to the situation nodes of "it is a motorcycle", "the weather is clear", "it is driving slowly", and "it is an 8-lane road" by relationship edges. The accident 3 node is connected to the situation nodes of "it is speeding", "it is 8-lane road", and "it is raining" by relationship edges. In this case, the relationship edge 430 may be given different weights depending on the degree of relationship between the accident node and the situation node.

The exclusivity edge 440 connects mutually exclusive situation nodes such as "foggy" and "clear weather", "clear weather" and "rainy", "hatchback vehicle" and "motorcycle", "two-lane rural road" and "eight-lane highway", and "speeding" and "driving slowly". In this case, the exclusivity edge 440 may also be given different weights depending on the degree of mutual exclusivity between situation nodes. In this case, the hatchback vehicle and the motorcycle are the subjects performing the driving scenario, and the connection of "It is a hatchback vehicle" and "It is a motorcycle" included in the vehicle situation node by the exclusivity edge 440 is because the subject performing the driving scenario cannot be both the hatchback vehicle and motorcycle. That is, because the subject included in the vehicle situation node is a subject performing the driving scenario, other subjects may be connected by exclusive edges.

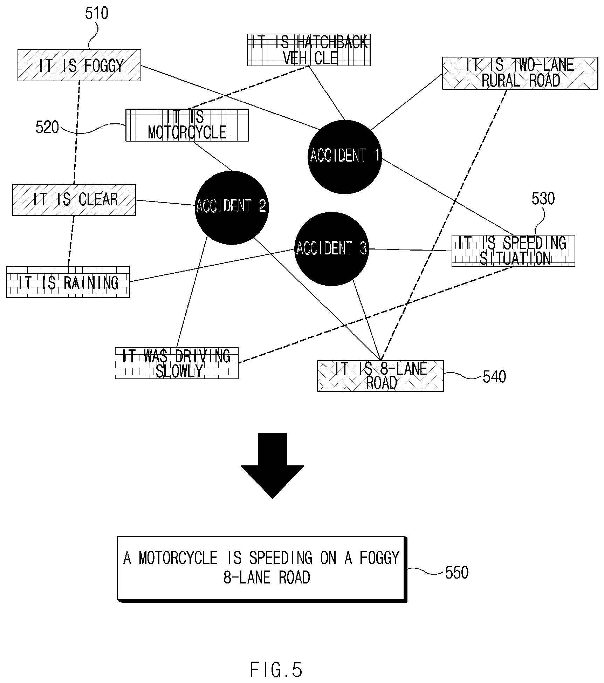

FIG. 5 is a diagram illustrating an example of a process of generating a driving scenario by using a situation graph, which illustrates an example of generating a driving scenario using the situation graph of FIG. 4.

As illustrated in FIG. 5, a method according to an embodiment of the present disclosure may generate a driving scenario by using situation nodes connected to an accident node through a relationship edge in a situation graph. In this case, the method according to an embodiment of the present disclosure may generate at least one driving scenario by utilizing weights assigned to relationship edges in a situation graph.

For example, a method according to an embodiment of the present disclosure may select a situation node 510 of "It is foggy" connected to the accident 1 node by a relationship edge, a situation node 520 of "It's a motorcycle" connected to the accident 2 node by a relationship edge, a situation node 530 of "It's a speeding situation" connected to the accident 1 node and the accident 3 node by relationship edges, and a situation node 540 of "It is an 8-lane road" connected to the accident 2 node and the accident 3 node by relationship edges, and may generate a driving scenario 550 of "A motorcycle is speeding on a foggy 8-lane road" by using the selected situation nodes 510, 520, 530 and 540.

Of course, it is possible to generate other driving scenarios by selecting other situation nodes connected through relationship edges in the situation graph. For example, a method according to an embodiment of the present disclosure may select a situation node "It is a two-lane rural road" connected to the accident 1 node by a relationship edge, a situation node "It is a motorcycle" connected to the accident 2 node by a relationship edge, a situation node "It is a speeding situation" connected to the accident 1 node and the accident 3 node by a relationship edge, and a situation node "It is raining" connected to the accident 3 node by a relationship edge, and generate a driving scenario "A motorcycle is speeding on a two-lane rural road when it is raining" using the selected situation nodes.

In addition, the method according to an embodiment of the present disclosure may generate a driving scenario by using situation nodes connected to at least two accident nodes through relationship edges.

The driving scenario generated by the above-described process may generate an image or video corresponding to the driving scenario by using various image generation models such as an image generation model and a video generation model. Of course, the generated image or video may necessarily include parts corresponding to the driving scenario, but may also include various other situations and surrounding objects. The image or video generated in such a manner may be used in the learning and verification process of autonomous driving, and because an image or video corresponding to a high-reliability driving scenario is used in the learning and verification process of autonomous driving, the reliability of learning and performance verification of the autonomous driving algorithm may be improved.

As described above, the method according to an embodiment of the present disclosure may generate a driving scenario based on generative artificial intelligence and automatically generate an image corresponding to the generated driving scenario.

In addition, the method according to an embodiment of the present disclosure may improve the reliability of learning and performance verification of an autonomous driving algorithm by generating a large number of driving scenarios in which accidents are likely to occur in devices such as vehicles performing autonomous driving, robots, and the like.

In addition, the method according to an embodiment of the present disclosure may reduce the cost and time invested in generating and verifying a driving scenario by automating the generation of a driving scenario based on generative artificial intelligence.

In addition, the method according to an embodiment of the present disclosure may reduce labor costs by constructing a driving scenario based on generative artificial intelligence, and may strengthen performance verification of autonomous driving products by enabling intensive verification of autonomous driving vulnerability cases.

Furthermore, the method of the present disclosure is not limited or restricted to collecting accident data to generate a driving scenario and an image related to the accident, and may be applied to various fields for generating a scenario, and the collected data may also vary depending on the application field. In addition, the method of the present disclosure may be applied to all kinds of devices or systems that may learn and verify using a scenario, and the fields, devices or systems to which the method is applied may be determined by a business operator or individual who provides the technology of the present disclosure.

In addition, the method of the present disclosure is not necessarily limited or restricted to generating a driving scenario after generating a situation graph, and may also generate a driving scenario by connecting edges between nodes, assigning weights, and using the weights assigned to the edges.

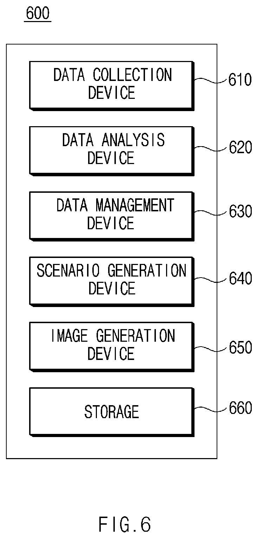

FIG. 6 is a block diagram illustrating a configuration of an apparatus for generating a driving scenario according to another embodiment of the present disclosure. FIG. 6 illustrates a configuration of an apparatus for generating a driving scenario that performs the methods of FIGS. 1 to 5. As an example, an apparatus for generating a driving scenario may be a server.

Referring to FIG. 6, an apparatus 600 for generating a driving scenario according to another embodiment of the present disclosure includes a data collection device 610, a data analysis device 620, a data management device 630, a scenario generation device 640, an image generation device 650, and storage 660.

The storage 660, which is a device for storing all data related to the technology of the present disclosure, stores collected data, generative artificial intelligence models, situation nodes, a driving scenario generation algorithms, generated driving scenarios and images, and the like.

The data collection device 610, which is a device for collecting data for generating a driving scenario, receives data obtained through various data acquisition devices, for example, vehicles, to collect data for generating a driving scenario.

In this case, the data collection device 610 may collect highly reliable data that has already been collected and stored.

The data analysis device 620 extracts situations in a text form from the collected data by using artificial intelligence such as generative artificial intelligence.

According to an embodiment, the data analysis device 620 may analyze the accident data by using generative artificial intelligence to which pre-collected or stored accident data is input and extract a situation in the form of text describing the situation. In this case, the data analysis device 620 may minimize the ambiguity of the results processed/analyzed by the generative artificial intelligence by extracting situations as phrases or sentences rather than words.

According to an embodiment, the data analysis device 620 may extract several situations that may contribute to an accident from accident data by using a language model or the like.

According to an embodiment, the data analysis device 620 may extract several situations that may contribute to an accident from a schematic diagram of an accident situation, a photo of an accident scene, and the like by using an image-to-text model and the like.

According to an embodiment, the situations extracted by the data analysis device 620 may be categorized according to situations such as weather, vehicle type, road type, and the like, and by embedding/clustering the situations using a language model within one category, similar situations may be managed as one and mutually exclusive situations may be identified.

The data management device 630 configures each situation extracted in a text form as a node and assigns weights to edges between nodes to generate a situation graph.

According to an embodiment, the data management device 630 may generate a situation graph by configuring each extracted situation as a situation node, configuring information on each accident data as an accident node, and then assigning weights to edges between the situation nodes and the accident nodes.

According to an embodiment, the data management device 630 may configure situation nodes as detailed situation nodes classified by category.

According to an embodiment, the data management device 630 may generate a situation graph by assigning weights to each of the relationship edges and exclusivity edges after connecting relationship edges between situation nodes that are related to accident nodes and connecting the exclusivity edges between mutually exclusive situation nodes among the situation nodes.

In this case, the relationship edge may be given different weights depending on the degree of relationship between the accident node and the situation node, and the exclusivity edge may be given different weights depending on the degree of exclusivity between the situation nodes.

According to an embodiment, the data management device 630 may assign different weights to the relational edges by considering the order in which it is highly related to the corresponding accident and has a great influence on the corresponding accident in relation to the accident node, and the highest and lowest weights assigned to the relationship edges may be determined in advance.

According to an embodiment, the data management device 630 may assign a lower weight to an exclusive edge connected between mutually exclusive situation nodes than a weight assigned to a relationship edge, and may assign different weights to the exclusive edge depending on the situation, or may assign the same weight of a preset small value. Of course, exclusivity edges may be weighted based on the degree of mutual exclusivity between situation nodes when the degree of mutual exclusivity may be calculated, and the higher the degree of mutual exclusivity, the higher or lower the weight that may be assigned to the exclusivity edge.

The scenario generation device 640 generates a driving scenario by using a situation graph.

According to an embodiment, the scenario generation device 640 may determine at least one situation node based on the weight assigned to the relationship edge among the situation nodes connected to the accident nodes through the relationship edge, and generate the driving scenario by using at least one situation node.

According to an embodiment, the scenario generation device 640 may generate a high-quality or high-likelihood driving scenario by identifying situation nodes with high accident contribution based on weights assigned to relationship edges by using graph algorithms such as GNN and PageRank, and including them at a specified ratio or higher.

That is, the scenario generation device 640 may generate a high-quality driving scenario by selecting situation nodes with high relationships based on the weights assigned to the relationship edges to generate a driving scenario.

The image generation device 650 generates an image or video corresponding to the generated driving scenario.

According to an embodiment, the image generation device 650 may generate a driving scenario as an image or video, or the like by using a generative artificial intelligence model such as a text-to-image or text-to-video model.

Even though the description is omitted in the apparatus according to another embodiment of the present disclosure, the apparatus according to another embodiment of the present disclosure may include all the contents described in the methods of FIGS. 1 to 5, which is obvious to a person skilled in the art.

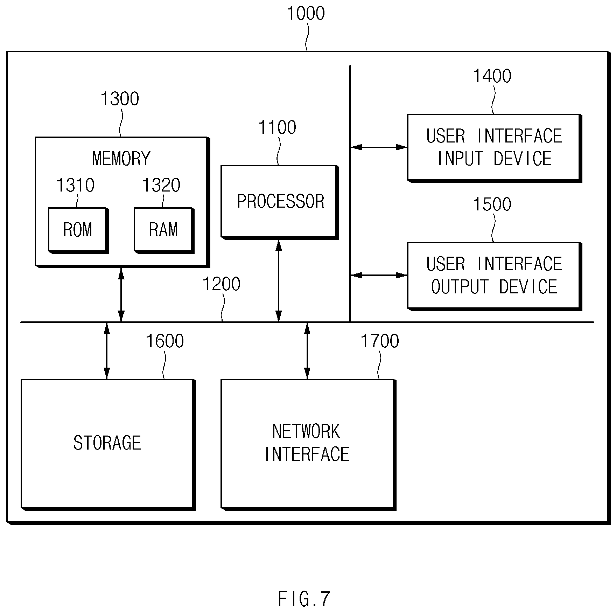

FIG. 7 is a block diagram illustrating a computing system for executing a method of generating a driving scenario according to an embodiment of the present disclosure.

Referring to FIG. 7, as described above, the method of generating a driving scenario according to an embodiment of the present disclosure may be implemented through a computing system. The computing system 1000 may include at least one processor 1100, a memory 1300, a user interface input device 1400, a user interface output device 1500, storage 1600, and a network interface 1700, which are connected through a system bus 1200.

The processor 1100 may be a central processing unit (CPU) or a semiconductor device that processes instructions stored in the memory 1300 and/or the storage 1600. The memory 1300 and the storage 1600 may include various volatile or nonvolatile storage media. For example, the memory 1300 may include a read only memory (ROM) 1310 and a random access memory (RAM) 1320.

Accordingly, the processes of the method or algorithm described in relation to the embodiments of the present disclosure may be implemented directly by hardware executed by the processor 1100, a software module, or a combination thereof. The software module may reside in a storage medium (that is, the memory 1300 and/or the storage 1600), such as a RAM memory, a flash memory, a ROM memory, an EPROM memory, an EEPROM memory, a register, a hard disk, a detachable disk, or a CD-ROM. The exemplary storage medium is coupled to the processor 1100, and the processor 1100 may read information from the storage medium and may write information in the storage medium. In another method, the storage medium may be integrated with the processor 1100. The processor 1100 and the storage medium may reside in an application specific integrated circuit (ASIC). The ASIC may reside in a user terminal. In another method, the processor 1100 and the storage medium may reside in the user terminal as an individual component.

According to the present disclosure, it is possible to generate a driving scenario based on generative artificial intelligence and automatically generate an image corresponding to the generated driving scenario.

According to the present disclosure, it is possible to improve the reliability of learning and performance verification of an autonomous driving algorithm by generating a large number of driving scenarios in which accidents are likely to occur in devices such as vehicles performing autonomous driving, robots, and the like.

According to the present disclosure, it is possible to reduce the cost and time invested in generating and verifying a driving scenario by automating the generation of a driving scenario based on generative artificial intelligence.

According to the present disclosure, it is possible to reduce labor costs by constructing a driving scenario based on generative artificial intelligence, and strengthen performance verification of autonomous driving products by enabling intensive verification of autonomous driving vulnerability cases.

Effects obtained by various embodiments of the disclosure may not be limited to the above, and other effects will be clearly understandable to those having ordinary skill in the art from the following disclosures.

Although exemplary embodiments of the present disclosure have been described for illustrative purposes, those skilled in the art will appreciate that various modifications, additions and substitutions are possible, without departing from the scope and spirit of the disclosure. Therefore, the exemplary embodiments disclosed in the present disclosure are provided for the sake of descriptions, not limiting the technical concepts of the present disclosure, and it should be understood that such exemplary embodiments are not intended to limit the scope of the technical concepts of the present disclosure. The protection scope of the present disclosure should be understood by the claims below, and all the technical concepts within the equivalent scopes should be interpreted to be within the scope of the right of the present disclosure.

## Claims

1. A method of generating a driving scenario, the method comprising:
extracting, by at least one processor, situations in a text form from collected data by using artificial intelligence (AI);
configuring, by the at least one processor, each of the situations extracted in the text form as a node and generating a situation graph by assigning a weight to an edge between nodes; and
generating, by the at least one processor, the driving scenario by using the situation graph.

2. The method of claim 1, wherein the extracting of the situations includes extracting the situations in the text form from the collected data related to an accident situation by using generative AI.

3. The method of claim 1 or 2, wherein the generating of the situation graph includes:
generating the situation graph by configuring the situations extracted in the text form into situation nodes;
configuring information for each of the collected data as accident nodes; and
assigning weights to edges after connecting the edges between the situation nodes and the accident nodes.

4. The method of claim 3, wherein the generating of the situation graph further includes:
generating the situation graph by assigning the weights to each of a first edge and a second edge after connecting the first edge between the situation nodes having a relationship with the accident nodes; and
connecting the second edge between mutually exclusive situation nodes among the situation nodes.

5. The method of claim 4,
wherein the first edge is given different weights depending on a degree of relationship between the accident nodes and the situation nodes, and
wherein the second edge is given different weights depending on a degree of exclusivity between the situation nodes.

6. The method of claim 4 or 5, wherein the generating of the driving scenario includes:
determining at least one situation node among the situation nodes connected to the accident nodes with the first edge based on the weight assigned to the first edge; and
generating the driving scenario by using the at least one situation node.

7. A method of generating a driving scenario, the method comprising:
extracting, by at least one processor, situations in a text form from collected data by using artificial intelligence (AI);
configuring, by the at least one processor, each of the situations extracted in the text form into situation nodes, and configuring information about each of the collected data as central nodes;
assigning, by the at least one processor, weights to edges by connecting the edges between the situation nodes and the central nodes; and
generating, by the at least one processor, the driving scenario based on the weights assigned to the edges.

8. The method of claim 7, wherein the assigning of the weights includes:
assigning the weights to each of a first edge and a second edge after connecting the first edge between the situation nodes having a relationship with the central nodes; and
connecting the second edge between mutually exclusive situation nodes among the situation nodes.

9. The method of claim 8, wherein the generating of the driving scenario includes:
determining at least one of the situation nodes connected to the central nodes with the first edge based on the weight assigned to the first edge; and
generating the driving scenario by using the at least one situation node.

10. An apparatus for generating a driving scenario, the apparatus comprising:
a data analysis device configured to extract situations in a text form from collected data by using artificial intelligence (AI);
a data management device configured to generate a situation graph by configuring each of the situations extracted in the text form as a node and assigning a weight to an edge between nodes; and
a scenario generation device configured to generate the driving scenario by using the situation graph.

11. The apparatus of claim 10, wherein the data analysis device is further configured to extract the situations in the text form from the collected data related to an accident situation by using generative AI.

12. The apparatus of claim 10 or 11, wherein the data management device is further configured to generate the situation graph by configuring the situations extracted in the text form into situation nodes, configuring information for each of the collected data as accident nodes, and assigning weights to edges after connecting the edges between the situation nodes and the accident nodes.

13. The apparatus of claim 12, wherein the data management device is further configured to generate the situation graph by assigning the weights to each of a first edge and a second edge after connecting the first edge between the situation nodes having a relationship with the accident nodes and connecting the second edge between mutually exclusive situation nodes among the situation nodes.

14. The apparatus of claim 13,
wherein the first edge is given different weights depending on a degree of relationship between the accident nodes and the situation nodes, and
wherein the second edge is given different weights depending on a degree of exclusivity between the situation nodes.

15. The apparatus of claim 13 or 14, wherein the scenario generation device is further configured to determine at least one of the situation nodes connected to the accident nodes with the first edge based on the weight assigned to the first edge, and to generate the driving scenario by using the at least one situation node.
